# EUROPEAN PATENT APPLICATION

(11) **EP 4 160 667 A1**
(43) Date of publication of application: **05.04.2023**
(21) Application number: 21818438.0
(22) Date of filing: 31.05.2021
(51) Int. Cl.: H01L 23/14, H05K 1/03, H05K 3/44

(54) **METHOD FOR MANUFACTURING INSULATED RESIN CIRCUIT BOARD**

(30) Priority: 02.06.2020 JP 2020095954
(71) Applicant: Mitsubishi Materials Corporation, Tokyo 100-8117 (JP)
(72) Inventor: SAKANIWA, Yoshiaki, Saitama-shi, Saitama 330-8508 (JP); OHASHI, Toyo, Saitama-shi, Saitama 330-8508 (JP)
(74) Representative: Hoffmann Eitle
(86) International application number: PCT/JP2021/020699
(87) International publication number: WO 2021/246369

(57) **Abstract**

There is provided a manufacturing method for an insulating resin circuit substrate, which is a manufacturing method for an insulating resin circuit substrate which includes an insulating resin layer composed of a polyimide resin and a circuit layer consisting of metal pieces disposed in a circuit pattern shape on one surface of the insulating resin layer. The manufacturing method includes a temporary fixing step of pressurizing the metal pieces toward the resin sheet material while heating the metal pieces to temporarily fix the metal pieces and a joining step of disposing a cushion material on a side of the metal pieces which are temporarily fixed and pressurizing the metal pieces and the resin sheet material in a laminating direction, while heating the metal pieces and the resin sheet material, to join the resin sheet material and the metal pieces. Regarding all the metal pieces, in a case where a ratio w/t of a minimum width w to a thickness t exceeds 0.5, a heating temperature in the temporary fixing step is 150°C or higher, and in a case where the metal pieces include a narrow-width metal piece having the ratio w/t of the minimum width w to the thickness t of 0.5 or less, the heating temperature in the temporary fixing step is 350°C or higher.

## Description

### TECHNICAL FIELD

The present invention relates to a manufacturing method for an insulating resin circuit substrate, where an insulating resin circuit substrate includes an insulating resin layer and a circuit layer consisting of a metal piece disposed in a circuit pattern shape on one surface of the insulating resin layer.

Priority is claimed on Japanese Patent Application No. 2020-095954, filed June 2, 2020, the content of which is incorporated herein by reference.

### BACKGROUND ART

A power module, an LED module, and a thermoelectric module have a structure in which a power semiconductor element, an LED element, and a thermoelectric element are joined to the insulating circuit substrate in which a circuit layer made of a conductive material is formed on one surface of an insulating layer.

As the above-described insulating circuit substrate, for example, a metal-based circuit substrate disclosed in Patent Document 1 has been proposed.

In the metal-based circuit substrate disclosed in Patent Document 1, the insulating resin layer is formed on a metal substrate, and the circuit layer having a circuit pattern is formed on the insulating resin layer.

In the metal-based circuit substrate, the semiconductor element is joined on the circuit layer, and a heat sink is disposed on a surface of the metal substrate on a side opposite to the insulating resin layer, and heat generated by the semiconductor element is transmitted to the heat sink side and is radiated.

Then, in the metal-based circuit substrate disclosed in Patent Document 1, a circuit pattern is formed by subjecting the copper foil disposed on the insulating resin layer to an etching treatment.

Here, there is a risk that sagging occurs on an end surface of the circuit layer, an electric field is concentrated on the end surface of the circuit layer, and thus there is a risk that insulating properties are deteriorated in a case where the circuit pattern is formed by the etching treatment as disclosed in Patent Document 1.

In particular, recently, the current applied to the semiconductor element mounted on the circuit layer tends to increase, and the amount of heat generated from the semiconductor element also increases accordingly. Accordingly, in order to ensure conductivity and thermal conductivity, it is required to thicken the circuit layer. Here, in a case where the circuit layer is thickened, the sagging easily occurs on end surface of the circuit layer after the etching treatment, and the insulating properties tend to be deteriorated.

Accordingly, as a method of forming the circuit layer without carrying out an etching treatment, Patent Document 2 proposes a technique in which a punched metal piece having a desired shape is joined to a ceramic substrate. According to the method, even in a case where the circuit layer is thickened, the sagging does not occur on an end surface of the metal piece, and the insulating properties between the circuit patterns can be ensured. Therefore, the distance between the circuit patterns can be reduced.

In this Patent Document 2, the ceramic substrate is used as the insulating layer, and the metal piece is joined to the ceramic substrate by pressurizing the metal piece to the ceramic substrate in a laminating direction.

### [Citation List]

### [Patent Documents]

[Patent Document 1]
   Japanese Unexamined Patent Application, First Publication No. 2015-207666
[Patent Document 2]
   Japanese Unexamined Patent Application, First Publication No. H09-135057

### SUMMARY OF INVENTION

### Technical Problem

By the way, in Patent Document 2, in a case where the insulating layer is composed of an insulating resin layer, metal pieces are disposed in a circuit pattern shape on one surface of a resin sheet material that becomes the insulating resin layer, and the metal pieces and the resin sheet material are pressurized is in the laminating direction. At this time, the resin sheet material is sufficiently pressurized in a region where the metal pieces are disposed; however, the resin sheet material is not sufficiently pressurized in a region where the metal pieces are not disposed. As a result, there is a risk that the characteristics of the insulating resin layer formed after joining vary.

Accordingly, it is conceivable that a metal piece is disposed in a circuit pattern shape on one surface of a resin sheet material, and a cushion material is disposed on a side of the metal piece to pressurize and heat the resin sheet material and the metal piece in a laminating direction to cure the resin composition, thereby forming the insulating resin layer and joining the insulating resin layer and the metal piece to each other. In this case, the cushion material can be deformed according to the shape of the metal piece, whereby the entire surface of the resin sheet material can be pressurized relatively uniformly.

However, in a case where the cushion material is disposed on the side of the metal piece and then the resin sheet material and the metal piece are pressurized in the laminating direction, the positional displacement of the metal piece may occur in association with the deformation of the cushion material. As a result, there is a risk that positional displacement occurs at the time of joining and it is impossible to form a circuit pattern of the circuit layer with high accuracy even in a case where the metal pieces are disposed on one surface of the resin sheet material with high accuracy.

The present invention has been made in consideration of the above-described circumstances, and an object of the present invention is to provide a manufacturing method for an insulating resin circuit substrate, with which metal pieces can be joined on a resin sheet material in a circuit pattern shape with good positional accuracy.

### Solution to Problem

In order to solve the above-described problems, the manufacturing method for an insulating resin circuit substrate according to the present invention is characterized by being a manufacturing method for an insulating resin circuit substrate which includes an insulating resin layer composed of a polyimide resin and a circuit layer consisting of metal pieces disposed in a circuit pattern shape on one surface of the insulating resin layer, the manufacturing method including: a metal piece disposing step of disposing the metal pieces in the circuit pattern shape on a resin sheet material to serve as the insulating resin layer; a temporary fixing step of pressurizing the metal pieces toward the resin sheet material while heating the metal pieces to temporarily fix the metal pieces; and a joining step of disposing a cushion material on a side of the metal pieces which are temporarily fixed and pressurizing the metal pieces and the resin sheet material in a laminating direction, while heating the metal pieces and the resin sheet material, to join the resin sheet material and the metal pieces, in which regarding all the metal pieces disposed on the resin sheet material, in a case where a ratio w/t of a minimum width w to a thickness t exceeds 0.5, a heating temperature in the temporary fixing step is 150°C or higher, and in a case where the metal pieces disposed on the resin sheet material include a narrow-width metal piece having the ratio w/t of the minimum width w to the thickness t of 0.5 or less, the heating temperature in the temporary fixing step is 350°C or higher.

According to the manufacturing method for an insulating resin circuit substrate having this configuration, a temporary fixing step of pressurizing the metal pieces toward the resin sheet material while heating the metal pieces to temporarily fix the metal pieces is provided, and thus the metal pieces can be positioned according to this temporary fixing step. It is noted that a cushion material is not used in this temporary fixing step, and thus the positional displacement of the metal piece does not occur.

In addition, the joining step is configured so that the pressurization is carried out by using the cushion material in a state where the metal piece is temporarily fixed, and thus the occurrence of the positional displacement of the metal piece is suppressed even in a case where the cushion material is deformed at the time of pressurization. As a result, it is possible to join the metal piece with good positional accuracy.

In addition, in the present embodiment, the insulating resin layer is made of a polyimide resin, and regarding all the metal pieces disposed on the resin sheet material, in a case where a ratio w/t of a minimum width w to a thickness t exceeds 0.5, a heating temperature in the temporary fixing step is 150°C or higher. As a result, it is possible to temporarily fix the metal piece with sufficient strength, and it is possible to suppress the positional displacement of the metal piece in the joining step.

On the other hand, in a case where the metal pieces disposed on the resin sheet material include a narrow-width metal piece having the ratio w/t of the minimum width w to the thickness t of 0.5 or less, the area of the side surface of the narrow-width metal piece becomes large with respect to the contact area with the resin sheet material, and the shear force acting on the narrow-width metal piece becomes relatively large in a case where the cushion material is deformed in the joining step. As a result, in a case of setting the heating temperature in the temporary fixing step to 350°C or higher, the narrow-width metal piece can be firmly fixed in the temporary fixing step, and the positional displacement of the narrow-width metal piece in the joining step can be suppressed.

Here, in the manufacturing method for an insulating resin circuit substrate according to the present invention, a heat radiation layer is formed on a surface of the insulating resin layer on a side opposite to one surface on which the circuit layer is formed, and the joining step may be configured so that a metal plate is disposed on a surface of the resin sheet material on a side opposite to a surface on which the metal pieces are disposed, and the resin sheet material and the metal plate are joined to form the heat radiation layer.

In this case, a heat radiation layer can be formed on the surface of the insulating resin layer on a side opposite to the circuit layer, and thus it is possible to manufacture an insulating circuit substrate having excellent heat radiation characteristics. In addition, in the joining step, since a cushion material is disposed on the side of the metal piece to carry out pressurization, the metal plate to serve as the heat radiation layer, and the resin sheet material can be uniformly pressurized, and the heat radiation layer and the insulating resin layer can be joined reliably.

### Advantageous Effects of Invention

According to the present invention, it is possible to provide a manufacturing method for an insulating resin circuit substrate, with which metal pieces can be joined on a resin sheet material in a circuit pattern shape with good positional accuracy.

### BRIEF DESCRIPTION OF DRAWINGS

FIG. 1 is a cross-sectional explanatory view of a power module using an insulating resin circuit substrate which is manufactured according to a manufacturing method for an insulating resin circuit substrate, which is an embodiment according to the present invention.
FIG. 2 is an explanatory view of the insulating resin circuit substrate which is manufactured according to the manufacturing method for an insulating resin circuit substrate, which is the embodiment according to the present invention. Here, (a) is a cross-sectional view of the side surface, and (b) is a top view.
FIG. 3 is a flowchart showing an example of the manufacturing method for an insulating resin circuit substrate, which is the embodiment according to the present invention.
FIG. 4 is an explanatory view showing an example of the manufacturing method for an insulating resin circuit substrate, which is the embodiment according to the present invention. Here, (a) shows a resin sheet material disposing step, (b) shows a metal piece disposing step, (c) shows a temporary fixing step, (d) shows a joining step, and (e) shows an obtained insulating resin circuit substrate.

### DESCRIPTION OF EMBODIMENTS

Hereinafter, embodiments according to the present invention will be described with reference to the accompanying drawings.

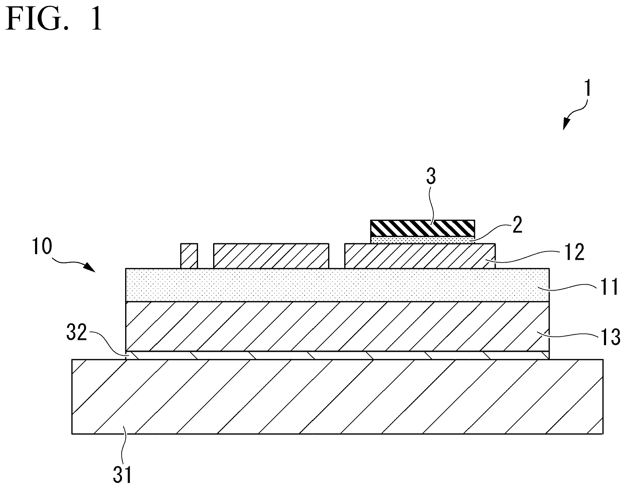

FIG. 1 shows an insulating resin circuit substrate 10 in an embodiment according to the present invention and a power module 1 using the insulating resin circuit substrate 10.

The power module 1 includes the insulating resin circuit substrate 10, a semiconductor element 3 joined to one side (the upper side in FIG. 1) of the insulating resin circuit substrate 10 via a solder layer 2, and a heat sink 31 joined to the other side (the lower side in FIG. 1) of the insulating resin circuit substrate 10 via a solder layer 32.

The solder layers 2 and 32 are, for example, Sn-Ag-based, Sn-Cu-based, Sn-In-based, or Sn-Ag-Cu-based solder materials (so-called lead-free solder materials).

The semiconductor element 3 is an electronic component including a semiconductor, and various semiconductor elements are selected according to a required function.

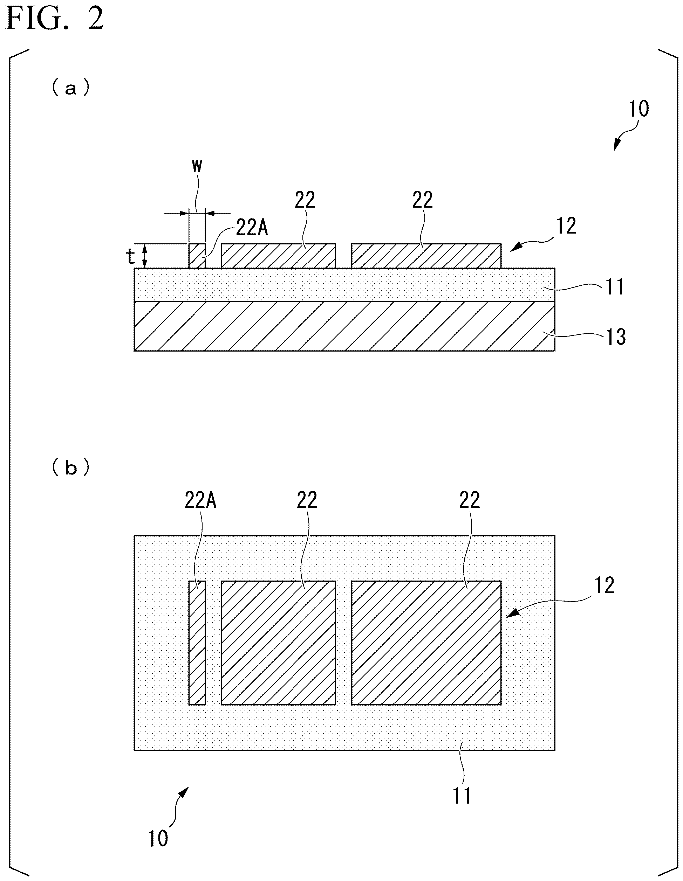

As shown in FIG. 1 and FIG. 2(a), the insulating resin circuit substrate 10 includes an insulating resin layer 11, a circuit layer 12 formed on one surface (the upper surface in FIG. 1 and FIG. 2(a)) of the insulating resin layer 11, and a heat radiation layer 13 formed on the other surface (the lower surface in FIG. 1 and FIG. 2(a)) of the insulating resin layer 11.

The insulating resin layer 11 prevents the electrical connection between the circuit layer 12 and the heat radiation layer 13, and it is made of a resin having insulating properties.

In the present embodiment, the insulating resin layer 11 is made of a polyimide resin. Further, the thickness of the insulating resin layer 11 is set to be within a range of 20 µm or more and 250 µm or less.

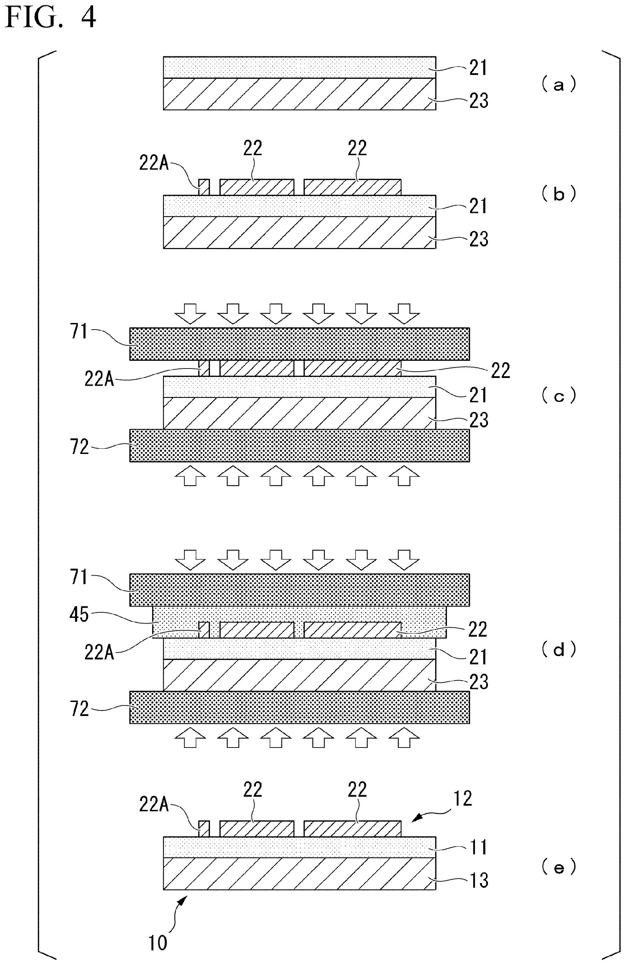

As shown in FIGS. 4(a) to 4(e), the circuit layer 12 is formed by joining the metal piece 22 made of a metal having excellent conductivity to one surface (the upper surface in FIGS. 4(a) to 4(e)) of the insulating resin layer 11. As the metal piece 22, the metal piece formed by subjecting a metal plate to a punching process can be used. In the present embodiment, as the metal piece 22 constituting the circuit layer 12, a metal piece obtained by subjecting a rolled plate of oxygen-free copper to a punching process is used. As the metal piece 22, it is also possible to use a metal piece obtained by subjecting copper such as tough pitch copper or a copper alloy to a punching process.

In the circuit layer 12, a circuit pattern is formed by disposing the metal piece 22 in a circuit pattern shape, and one surface (the upper surface in FIG. 1) of the circuit pattern is a mounting surface on which the semiconductor element 3 is mounted.

Here, in the present embodiment, as shown in FIG. 2, a narrow-width metal piece 22A having a ratio w/t of 0.5 or less is disposed as one of the metal pieces 22, on one surface of the insulating resin layer 11 (the upper surface in FIG. 2(a)), where the ratio w/t is a ratio of a minimum width w to a thickness t.

In the present embodiment, the thickness t of the circuit layer 12 (the metal piece 22) is preferably 0.5 mm or more, more preferably 1.0 mm or more, and still more preferably 1.5 mm or more. In addition, although the upper limit of the thickness t of the circuit layer 12 (metal piece 22) is not particularly limited, it is practically 4.0 mm or less.

The heat radiation layer 13 has an effect of improving the heat radiation characteristics by spreading heat generated in the semiconductor element 3 mounted on the insulating resin circuit substrate 10 in the plane direction. Therefore, the heat radiation layer 13 is made of a metal having excellent thermal conductivity, for example, a copper or a copper alloy, an aluminum or an aluminum alloy.

In the present embodiment, it is made of a rolled plate of oxygen-free copper. In addition, the thickness of the heat radiation layer 13 is set to be within a range of 0.05 mm or more and 5.0 mm or less.

The heat sink 31 is for radiating heat on the side of the insulating resin circuit substrate 10. The heat sink 31 is made of copper or a copper alloy, aluminum, an aluminum alloy, or the like having good thermal conductivity. In the present embodiment, a heat radiation plate is made of the oxygen-free copper. It is noted that the thickness of the heat sink 31 is set to be within a range of 3 mm or more and 10 mm or less.

Here, the heat radiation layer 13 of the insulating resin circuit substrate 10 and the heat sink 31 are joined via the solder layer 32.

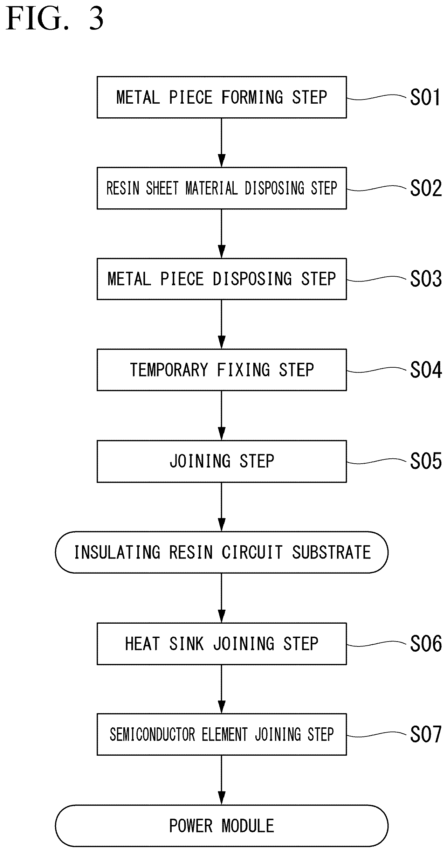

Hereinafter, a manufacturing method for the insulating resin circuit substrate 10 according to the present embodiment will be described with reference to FIG. 3 and FIGS. 4(a) to 4(e).

### (Metal Piece Forming Step S01)

First, the metal piece 22 (including the narrow-width metal piece 22A) to serve as the circuit layer 12 is formed. The metal plate (the rolled plate of the oxygen-free copper in the present embodiment) is subjected to a punching process to form the metal piece 22 (including the narrow-width metal piece 22A).

### (Resin Sheet Material Disposing Step S02)

Next, as shown in FIG. 4(a), a resin sheet material 21 consisting of a polyimide resin is disposed on one surface (the upper surface in FIG. 4(a)) of the metal plate 23 to serve as the heat radiation layer 13.

### (Metal Piece Disposing Step S03)

Next, a plurality of metal pieces 22 (including the narrow-width metal pieces 22A) are disposed in a circuit pattern shape on one surface (the upper surface in FIG. 4(b)) of the resin sheet material 21. In the present embodiment, the metal piece 22 having a ratio w/t of 0.5 or less was disposed as the narrow-width metal piece 22A, where the ratio w/t was a ratio of the minimum width w to the thickness t.

### (Temporary Fixing Step S04)

Next, as shown in FIG. 4(c), the metal plate 23 to serve as the heat radiation layer 13, the resin sheet material 21, and the metal piece 22 (including the narrow-width metal piece 22A) are disposed between an upper pressing plate 71 and a lower pressing plate 72 of a pressurizing device and then pressurized in the laminating direction while being heated.

At this time, the metal piece 22 (including the narrow-width metal piece 22A) is pressurized toward the resin sheet material 21, and a region on one surface of the resin sheet material 21, where the metal piece 22 (including the narrow-width metal piece 22A) is not disposed, is not pressurized.

Due to this temporary fixing step S04, the metal piece 22 (including the narrow-width metal piece 22A) is in a state of being positioned.

Here, in this temporary fixing step S04, it is preferable to set the heating temperature to 150°C or higher. In the present embodiment, since the metal piece 22 is disposed including the narrow-width metal piece 22A having a ratio w/t of 0.5 or less, where the ratio w/t is a ratio of a minimum width w to a thickness t, it is preferable to set the heating temperature to 350°C or more. It is noted that it is preferable to set the upper limit of the heating temperature to 400°C or lower.

In addition, in the temporary fixing step S04, it is preferable that a holding time at the heating temperature is set to be within a range of 10 minutes or more and 120 minutes or less. The lower limit of the holding time at the heating temperature is preferably 30 minutes or more, and more preferably 45 minutes or more. On the other hand, the upper limit of the holding time at the heating temperature is preferably 90 minutes or less, and more preferably 60 minutes or less.

Furthermore, in the temporary fixing step S04, it is preferable that the pressurization load in the laminating direction is set to be within a range of 0.5 MPa or more and 10 MPa or less. The lower limit of the pressurization load in the laminating direction is preferably 1.0 MPa or more and more preferably 3.0 MPa or more. On the other hand, the upper limit of the pressurization load in the laminating direction is preferably 8.0 MPa or less, and more preferably 5.0 MPa or less.

### (Joining Step S05)

Next, the metal plate 23 to serve as the heat radiation layer 13, the resin sheet material 21, and the temporarily fixed metal piece 22 (including the narrow-width metal piece 22A) are pressurized in the laminating direction while being heated. At this time, as shown in FIG. 4(d), a cushion material 45 is disposed on the side of the metal piece 22 (the side of the upper pressing plate 71), and the upper pressing plate 71 and the lower pressing plate 72 are configured to pressurize the metal piece 22 (including the narrow-width metal piece 22A) and the resin sheet material 21 in the laminating direction.

Due to the cushion material 45, it is possible to pressurize a region on one surface of the resin sheet material 21, where the metal piece 22 (including the narrow-width metal piece 22A) is not disposed. Here, the cushion material 45 is made of a material softer than that of the upper pressing plate 71, and it is made of, for example, silicone rubber.

Due to this joining step S05, the metal plate 23, the resin sheet material 21, and the metal piece 22 (including the narrow-width metal piece 22A) are joined to form the circuit layer 12, the insulating resin layer 11, and the heat radiation layer 13.

Here, in the joining step S05, it is preferable that the heating temperature is set to be within a range of 150°C or higher and 400°C or lower. It is noted that the lower limit of the heating temperature is more preferably 250°C or higher and still more preferably 300°C or higher. On the other hand, the upper limit of the heating temperature is preferably 380°C or lower and more preferably 350°C or lower.

In addition, in the joining step S05, it is preferable that a holding time at the heating temperature is set to be within a range of 10 minutes or more and 120 minutes or less. It is noted that the lower limit of the holding time at the heating temperature is preferably 30 minutes or more and more preferably 45 minutes or more. On the other hand, the upper limit of the holding time at the heating temperature is preferably 60 minutes or less and more preferably 90 minutes or less.

Furthermore, in the joining step S05, it is preferable that the pressurization load in the laminating direction is set to be within a range of 0.5 MPa or more and 10 MPa or less. It is noted that the lower limit of the pressurization load in the laminating direction is preferably 1.0 MPa or more and more preferably 3.0 MPa or more.

On the other hand, the upper limit of the pressurization load in the laminating direction is preferably 5.0 MPa or less and more preferably 8.0 MPa or less.

As shown in FIG. 4(e), the insulating resin circuit substrate 10 which is the present embodiment is manufactured according to each of the steps described above.

### (Heat Sink Joining Step S06)

Next, the heat sink 31 is joined to the other surface of the heat radiation layer 13 of the insulating resin circuit substrate 10. In the present embodiment, the heat radiation layer 13 and the heat sink 31 are joined via the solder material.

### (Semiconductor Element Joining Step S07)

Then, the semiconductor element 3 is joined to the circuit layer 12 of the insulating resin circuit substrate 10. In the present embodiment, the circuit layer 12 and the semiconductor element 3 are joined via a solder material 2.

According to the above steps, the power module 1 shown in FIG. 1 is manufactured.

According to the manufacturing method for the insulating resin circuit substrate 10, which is the present embodiment configured as described above, a temporary fixing step S04 of pressurizing the metal pieces 22 toward the resin sheet material 21 to temporarily fix the metal pieces 22 while being heating is provided, and thus the metal pieces 22 can be positioned according to this temporary fixing step S04. It is noted that a cushion material 45 is not used in this temporary fixing step S04, and thus the positional displacement of the metal piece 22 does not occur.

In addition, the joining step S05 is configured so that the pressurization is carried out by using the cushion material 45 in a state where the metal piece 22 is temporarily fixed, the occurrence of the positional displacement of the metal piece 22 is suppressed even in a case where the cushion material 45 is deformed at the time of pressurization. As a result, it is possible to join the metal piece 22 with good positional accuracy.

In the present embodiment, in a case where the insulating resin layer 11 (the resin sheet material 21) is made of a polyimide resin and the heating temperature in the temporary fixing step S04 is set to 150°C or higher, it is possible to temporarily fix the metal piece 22 with sufficient strength in the temporary fixing step S04, and it is possible to further suppress the positional displacement of the metal piece 22 in the joining step S05.

In addition, in the present embodiment, in a case where the narrow-width metal piece 22A having a ratio w/t of 0.5 or less is disposed on one surface of the resin sheet material 21, where the ratio w/t is a ratio of the minimum width w to the thickness t, and the heating temperature in the temporary fixing step S04 is 350°C or higher, the narrow-width metal piece 22A can be firmly fixed in the temporary fixing step S04, and the positional displacement of the narrow-width metal piece 22A in the joining step S05 can be suppressed.

Further, in the present embodiment, in the joining step S05, the metal plate 23 is disposed on a surface of the resin sheet material 21 opposite to a surface on which the metal pieces 22 are disposed, and the resin sheet material 21 and the metal plate 23 are configured to be joined to form the heat radiation layer 13. As a result, a heat radiation layer 13 can be formed on the surface of the insulating resin layer 11 on a side opposite to the circuit layer 12, and thus it is possible to manufacture an insulating circuit substrate 10 having excellent heat radiation characteristics. In addition, in the joining step S05, since a cushion material 45 is disposed on the side of the metal piece 22 to carry out pressurization, the metal plate 23 to serve as the heat radiation layer 13, and the resin sheet material 21 to serve as the insulating resin layer 11 can be uniformly pressurized, and the heat radiation layer 13 and the insulating resin layer 11 can be joined reliably.

The embodiments according to the present invention have been described as above; however, the present invention is not limited to this, and they can be appropriately changed without departing from the technical ideas of the present invention.

For example, it has been described in the present embodiment that a power semiconductor element is mounted on the circuit layer of the insulating resin circuit substrate to constitute a power module; however, the present invention is not limited to this. For example, an LED element may be mounted on an insulating resin circuit substrate to form an LED module, or a thermoelectric element may be mounted on a circuit layer of an insulating resin circuit substrate to form a thermoelectric module.

In addition, although it has been described in the present embodiment that the insulating resin circuit substrate (the metal substrate) and the heat sink are joined via the solder layer, the present invention is not limited to this, and the insulating resin circuit substrate (the metal substrate) and the heat sink may be laminated via grease.

Further, the material and structure of the heat sink are not limited to the present embodiment, and the design may be changed as appropriate.

Although it has been described in the present embodiment that the metal piece forming step S01 of forming the metal piece 22 (including the narrow-width metal piece 22A) is provided by punching the metal plate, the present invention is not limited to this, and metal pieces formed by other means may be used.

Further, although it has been described in the present embodiment that in the joining step, the metal plate is joined together with the metal piece, and a heat radiation layer is formed on the other surface side of the insulating resin layer, the present invention is not limited to this, and the heat radiation layer may not be formed.

### [Examples]

Hereinafter, the results of confirmation experiments carried out to confirm the effects of the present invention will be described.

A rolled plate of oxygen-free copper (50 mm × 60 mm × thickness 2.0 mm) was prepared as a metal plate to serve as the heat radiation layer, and a resin sheet material (50 mm × 60 mm × thickness 0.05 mm) made of a polyimide resin was disposed on one surface of the metal plate.

Then, metal pieces (including narrow-width metal pieces) shown in Table 1 were disposed in a pattern shape on one surface of the resin sheet material. At this time, the metal pieces (including narrow-width metal pieces) were disposed so that the closest distance between adjacent metal pieces was 1 mm.

As the temporary fixing step, under the conditions shown in Table 1, the metal pieces (including the narrow-width metal pieces) were pressurized toward the side of the resin sheet material while being heated. It is noted that the cushion material was not used in this temporary fixing step.

Next, as the joining step, under the conditions shown in Table 1, the metal plate, the resin sheet material, and the metal pieces (including the narrow-width metal pieces) were pressurized in the laminating direction while being heated, and the metal plate, the insulating resin layer, and the metal pieces (the metal plate) were joined. At this time, a rubber-like elastic body (thickness: 4.0 mm) consisting of silicone rubber was disposed on one side of the metal piece and pressurized in the laminating direction.

Regarding the insulating resin circuit substrate obtained as described above, the positional displacement of the metal pieces (including the narrow-width metal pieces) was evaluated as follows.

Using an image dimension measuring instrument (IM-7030T) manufactured by KEYENCE Corporation, the spacing between the metal pieces was measured after the temporary fixing step (before the joining step) and after the joining step, and each of the maximum and minimum values thereof was determined.

Then, the maximum value of the spacing between the metal pieces after the temporary fixing step (before the joining step) and the maximum value of the spacing between the metal pieces after the joining step, and the minimum value of the spacing between the metal pieces after the temporary fixing step (before the joining step) and the minimum value of the spacing between the metal pieces after the joining step were compared a case where each of rates of change was 10% or less evaluated as "A", and a case where at least any one of the rates of change exceeded 10% was evaluated as "B".

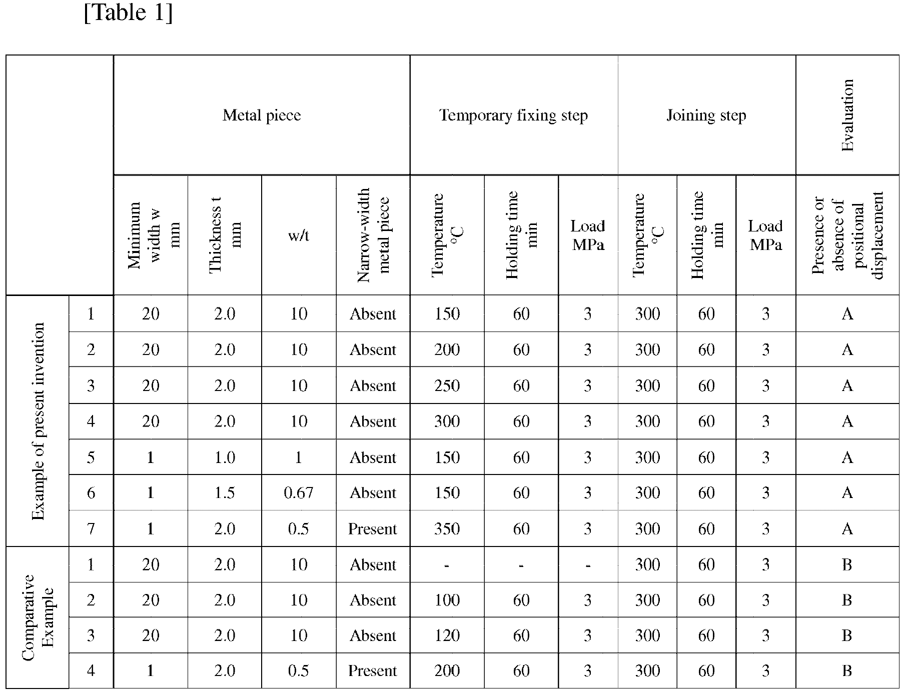

In Comparative Example 1, the temporary fixing step was not carried out, and the rates of change in the maximum value and the minimum value of the spacing between the metal pieces after the temporary fixing step (before the joining step) and after the joining step exceeded 10%. As a result, the evaluation of the positional displacement of the metal piece was "B (unacceptable)"

In Comparative Examples 2 and 3, the heating temperature at the time of the temporary fixing step was less than 150°C, and the rates of change in the maximum value and the minimum value of the spacing between the metal pieces after the temporary fixing step (before the joining step) and after the joining step exceeded 10%. As a result, the evaluation of the positional displacement of the metal piece was "B (unacceptable)"

In Comparative Example 4, although a narrow-width metal piece having a ratio w/t of 0.5 or less was disposed, where the ratio w/t is a ratio of a minimum width w to a thickness t, the heating temperature at the time of the temporary fixing step was 200°C, and in this narrow-width metal piece, the rates of change in the maximum value and the minimum value of the spacing between the adjacent metal pieces after the temporary fixing step (before the joining step) and after the joining step exceeded 10%. As a result, the evaluation of the positional displacement of the metal piece was "B (unacceptable)"

On the other hand, in Examples 1 to 6 according to the present invention in which the narrow-width metal piece was not provided and the heating temperature in the temporary fixing step was 150°C or higher, the rates of change in the maximum value and the minimum value of the spacing between the metal pieces after the temporary fixing step (before the joining step) and after the joining step was 10% or less. As a result, the evaluation of the positional displacement of the metal piece was "A (acceptable)"

In Example 7 of the present invention, although a narrow-width metal piece having a ratio w/t of 0.5 or less was provided, where the ratio w/t is a ratio of a minimum width w to a thickness t, the heating temperature at the time of the temporary fixing step was 350°C, and in this narrow-width metal piece, both the rates of change in the maximum value and the minimum value of the spacing between the adjacent metal pieces after the temporary fixing step (before the joining step) and after the joining step was 10% or less. As a result, the evaluation of the positional displacement was "A (acceptable)"

From the above results, it has been confirmed that according to the examples of the present invention, it is possible to provide a manufacturing method for an insulating resin circuit substrate, with which metal pieces can be joined on a resin sheet material in a circuit pattern shape with good positional accuracy.

### [Reference Signs List]

1: Power module
3: Semiconductor element
10: Insulating resin circuit substrate
11: Insulating resin layer
12: Circuit layer
13: Heat radiation layer
21: Resin sheet material
22: Metal piece
22A: narrow-width metal piece
23: Metal plate
45: Cushion material

## Claims

1. A manufacturing method for an insulating resin circuit substrate which includes an insulating resin layer composed of a polyimide resin and a circuit layer consisting of metal pieces disposed in a circuit pattern shape on one surface of the insulating resin layer, the manufacturing method comprising:
a metal piece disposing step of disposing the metal pieces in the circuit pattern shape on a resin sheet material to serve as the insulating resin layer;
a temporary fixing step of pressurizing the metal pieces toward the resin sheet material while heating the metal pieces to temporarily fix the metal pieces; and
a joining step of disposing a cushion material on a side of the metal pieces which are temporarily fixed and pressurizing the metal pieces and the resin sheet material in a laminating direction, while heating the metal pieces and the resin sheet material, to join the resin sheet material and the metal pieces,
wherein regarding all the metal pieces disposed on the resin sheet material, in a case where a ratio w/t of a minimum width w to a thickness t exceeds 0.5, a heating temperature in the temporary fixing step is 150°C or higher, and
in a case where the metal pieces disposed on the resin sheet material include a narrow-width metal piece having the ratio w/t of the minimum width w to the thickness t of 0.5 or less, the heating temperature in the temporary fixing step is 350°C or higher.

2. The manufacturing method for an insulating resin circuit substrate according to Claim 1,
wherein a heat radiation layer is formed on a surface of the insulating resin layer on a side opposite to one surface on which the circuit layer is formed, and
in the joining step, a metal plate is disposed on a surface of the resin sheet material on a side opposite to a surface on which the metal pieces are disposed, and the resin sheet material and the metal plate are joined to form the heat radiation layer.
